# FASCICULE DE BREVET EUROPEEN

(11) **EP 2 546 189 B1**
(45) Date de publication et mention de la délivrance du brevet: **12.02.2020**
(21) Numéro de dépôt: 12175740.5
(22) Date de dépôt: 10.07.2012
(51) Int. Cl.: B81C 3/00, G01P 15/125, G01C 19/5769

(54) **Procédé de réalisation d'une structure à électrode enterrée par report direct**
Verfahren zur Herstellung einer Struktur mit einer vergrabenen Elektrode durch direkte Übertragung
Method for producing a structure having a buried electrode by direct transfer

(30) Priorité: 12.07.2011 FR 1156351
(43) Date de publication de la demande: 16.01.2013
(73) Titulaire: Commissariat à l'Énergie Atomique et aux Énergies Alternatives, 75015 Paris (FR); NXP USA, Inc., Austin TX 78735 (US)
(72) Inventeur: Berthelot, Audrey, 38330 St Ismier (FR); Larrey, Vincent, 38140 La Murette (FR); Polizzi, Jean-Philippe, 38000 Grenoble (FR); Vaudaine, Marie-Hélène, 38180 Seyssins (FR); Desai, Hemant, Gilbert, AZ 85296 (US); Park, Woo Tae, 098830 Singapore (SG)
(74) Mandataire: Ilgart, Jean-Christophe

(56) Documents cités:
- WO-A1-2007/135878
- US-B1- 6 761 068
- AWAN S A ET AL: "Optimized Design and Process for Making a DC Voltage Reference Based on MEMS", IEEE TRANSACTIONS ON INSTRUMENTATION AND MEASUREMENT, IEEE SERVICE CENTER, PISCATAWAY, NJ, US, vol. 54, no. 2, 1 avril 2005 (2005-04-01), pages 563-566, XP011128181, ISSN: 0018-9456, DOI: 10.1109/TIM.2005.843582
- YAMAMOTO T ET AL: "Capacitive accelerometer with high aspect ratio single crystalline silicon microstructure using the SOI structure with polysilicon-based interconnect technique", 20000123; 20000123 - 20000127, 23 janvier 2000 (2000-01-23), pages 514-519, XP010377180,
- PLOSZL A ET AL: "Wafer direct bonding: tailoring adhesion between brittle materials", MATERIALS SCIENCE AND ENGINEERING R: REPORTS, ELSEVIER SEQUOIA S.A., LAUSANNE, CH, vol. 25, no. 1-2, 10 mars 1999 (1999-03-10), pages 1-88, XP004167445, ISSN: 0927-796X, DOI: 10.1016/S0927-796X(98)00017-5

## Description

### DOMAINE TECHNIQUE ET ART ANTERIEUR

L'invention concerne le domaine des micro et nano-systèmes et la fabrication de ces derniers.

Dans ce type de dispositif, des structures mécaniques mobiles sont réalisées en gravant sélectivement les couches de matériaux, ou couches sacrificielles, qui se trouvent sous la structure mobile.

L'invention permet notamment de réaliser des gyroscopes, avec éléments de détection à électrodes capacitives parallèles, au-dessus et au-dessous de la couche structurée mobile.

La présente invention s'applique plus particulièrement au domaine des Microsystèmes, avec éléments de détection à électrodes capacitives parallèles au plan de la partie mobile réalisée dans une couche mince structurée (par exemple des micro-gyromètres).

Comme exemple d'un tel système on peut citer le MEMS décrit dans le document US2006/0208326. Dans ce document, un scellement métallique hermétique AlGe est réalisé entre deux substrats. On trouve une structure mobile MEMS dans le premier substrat. Le second substrat (Capot) peut être un CMOS avec une électrode supérieure en aluminium.

La fabrication de telles microstructures peut se faire par différentes méthodes connues.

En particulier, on peut les réaliser à partir d'un substrat Si de type « bulk », sur lequel on dépose ou fait croître une couche sacrificielle (par exemple SiO2), puis la couche structurelle (par exemple du silicium polycristallin). On peut, alors, structurer le substrat en silicium bulk, avant dépôt des couches sacrificielles et structurelles pour obtenir par exemple des électrodes ou connexions.

Cependant, dans ce cas, la couche structurelle ne peut pas être du silicium monocristallin, car il n'est pas possible de déposer ou faire croître du silicium monocristallin sur une couche isolante, ou d'autre nature que du silicium monocristallin. De plus, cette couche structurelle, non monocristalline, a des propriétés mécaniques dégradées par rapport au silicium monocristallin. Enfin il n'est pas possible de déposer des couches structurelles épaisses à cause des temps de traitement très longs et du caractère coûteux qui en résulte.

En outre se pose le problème du stress généré par des couches épaisses, comme expliqué dans le document Ganchandani et al. Impact of long, high temperature anneals on residual stress in polysilicon, 1997 International Conference on Solid-State Sensor and Actuators.

En variante, il est possible de fabriquer un microsystème à partir de 2 substrats de silicium, dont l'un est recouvert d'une couche d'oxyde. Les deux substrats sont assemblés par collage direct.

Comme exemple d'un tel système, on peut citer celui décrit dans l'article de Yamamoto et al. Intitulé : « Capacitive Accelerometer with high aspect ratio single microstructure Using the SOI structure with polysilicon-based Interconnect technique », qui décrit la fabrication de MEMS à partir d'un collage direct de 2 substrats. Sur un premier substrat, après dépôt d'une couche d'oxyde, une couche de silicium poly-cristallin est déposée, puis structurée pour former une électrode inférieure. Après dépôt et polissage d'une nouvelle couche d'oxyde, le substrat est collé par collage direct à un autre substrat de silicium, puis aminci par la face structurée. Le MEMS est ensuite structuré dans le substrat aminci par DRIE, puis libéré par gravure de la couche sacrificielle.

Cette méthode de fabrication présente 2 inconvénients.

Tout d'abord, après collage direct et amincissement, les premiers niveaux et les marques d'alignement sont enterrés et donc invisibles. Or, il faut pouvoir aligner les niveaux suivants (notamment le niveau MEMS) sur les premiers niveaux enterrés (notamment l'électrode inférieure). L'article de Yamamoto et al. cité ci-dessus propose de générer des marques d'alignement profonde au début du procédé de fabrication et de les remplir d'oxyde et enfin de les retrouver après amincissement. Une autre méthode est de générer des marques d'alignement sur la face arrière du second substrat et de faire un scellement des 2 substrats avec alignement. Après amincissement, les marques face arrière du second substrat seraient utilisées pour l'alignement des niveaux suivants.

Par ailleurs, avec cette méthode de fabrication, il n'est pas possible de créer un contact de l'électrode inférieure au substrat.

Le document WO 2007/135878 A1 décrit un procédé pour réaliser un dispositif de type Micro-système, le procédé comportant la formation d'un premier substrat disposant d'une électrode inférieure et d'espaceurs; la réalisation d'une partie mobile dans un substrat intermédiaire préalablement à une étape d'assemblage de ce substrat intermédiaire avec le premier substrat; l'assemblage du substrat intermédiaire avec le premier substrat, les espaceurs permettant de définir une cavité sous la partie mobile; puis, l'assemblage d'un substrat supérieur, avec le substrat intermédiaire, de sorte que la partie mobile puisse être mise en mouvement entre l'électrode inférieure et le substrat supérieur.

Enfin, la technique décrite dans le document US2010/0193884 met en oeuvre la formation d'un MEMS avec une électrode inférieure et une électrode supérieure, grâce à 2 scellements métalliques.

L'inconvénient de cette méthode est que le budget thermique doit être restreint après le premier scellement métallique et la formation de l'électrode inférieure.

En outre, dans cette technique, les 2 substrats sont structurés séparément. Ils sont ensuite scellés (par scellement métallique) avec un alignement des 2 substrats, ce qui nécessite un équipement particulier et coûteux.

Il se pose donc le problème de trouver un nouveau procédé de réalisation d'une structure de type micro et/ou nano-systèmes, ne présentant pas les inconvénients expliqués ci-dessus.

### EXPOSÉ DE L'INVENTION

On décrit d'abord un dispositif de type micro et/ou nano-systèmes par exemple MEMS et/ou NEMS obtenu par le procédé selon l'invention. Ce dispositif comporte:
- un premier substrat, muni d'au moins une électrode inférieure, et d'une couche diélectrique, disposée entre l'électrode inférieure et le premier substrat ; ce premier substrat, ou substrat inférieur, peut être par exemple en un matériau semi-conducteur monocristallin ou polycristallin ou bien il comporte un substrat SOI ou comporte plusieurs matériaux empilés ;
- un substrat intermédiaire comportant une partie mobile, assemblé, hors de la partie mobile, par collage moléculaire avec le premier substrat, la partie mobile étant en regard d'au moins une partie de l'électrode inférieure,
- un substrat supérieur, assemblé au substrat intermédiaire, par exemple de type CMOS, ladite partie mobile pouvant être mise en mouvement entre l'électrode inférieure et le substrat supérieur.

La ou les électrodes permettent d'initier ou de détecter la composante, perpendiculaire au plan principal du dispositif, du mouvement de la partie mobile ; mais ce mouvement de la partie mobile peut, en outre, avoir d'autres composantes, en particulier dans un plan parallèle à ce plan principal.

Cette structure permet d'éviter une contrainte sur le budget thermique après la formation de l'électrode inférieure. En effet, elle permet de générer une liaison entre le substrat intermédiaire et le premier substrat, ou une partie de la couche diélectrique formée sur ce dernier, ce qui permet de ne pas imposer de limite en température pour les étapes postérieures à la formation de l'électrode inférieure.

Le substrat supérieur peut comporter au moins une électrode, la partie mobile étant en regard d'au moins une partie de cette électrode supérieure, et pouvant être mise en mouvement entre l'électrode inférieure et l'électrode supérieure.

Le substrat supérieur peut être scellé au substrat intermédiaire à l'aide d'un cordon de scellement.

Des moyens peuvent être prévus pour former contact électrique entre l'électrode inférieure et l'électrode supérieure et/ou des moyens peuvent être prévus pour former contact électrique entre l'électrode inférieure et le premier substrat.

Le substrat intermédiaire est de préférence en silicium monocristallin.

On décrit également un procédé selon l'invention pour réaliser un dispositif de type MEMS et/ou NEMS comportant les étapes suivantes :
- former un premier substrat, comportant au moins une électrode, dite inférieure, et une première couche diélectrique,
- suivie par l'assemblage, par collage moléculaire, d'un substrat intermédiaire, avec le premier substrat,
- suivie par la définition d'une partie mobile dans le substrat intermédiaire,
- suivie par la formation d'une cavité dans la première couche diélectrique, libérant ainsi la partie mobile, de façon à ce que celle-ci soit en regard d'au moins une partie de l'électrode inférieure,
- suivie par l'assemblage d'un substrat, dit substrat supérieur, avec le substrat intermédiaire, de sorte que ladite partie mobile puisse être mise en mouvement entre l'électrode inférieure et le substrat supérieur, au moins suivant une direction perpendiculaire à cette électrode inférieure et, éventuellement, dans un plan parallèle au plan principal ou à cette électrode inférieure. La ou les électrodes permettent donc d'initier ou de détecter la composante, perpendiculaire au plan principal du dispositif, du mouvement de la partie mobile, étant entendu que ce mouvement de la partie mobile peut avoir d'autres composantes, en particulier dans un plan parallèle à ce plan principal.

Le substrat supérieur peut comporter au moins une électrode, dite supérieure, l'assemblage étant tel que la partie mobile soit en regard d'au moins une partie de l'électrode supérieure, ladite partie mobile pouvant être mise en mouvement entre l'électrode inférieure et l'électrode supérieure.

Des marques d'alignement peuvent être réalisées en face arrière du substrat inférieur. Il est ensuite possible de sceller ce substrat inférieur structuré avec le substrat intermédiaire, non structuré. Ce scellement peut se faire sans équipement particulier. Une fois le substrat intermédiaire éventuellement aminci, les différents niveaux sont alignés sur les marques générées en face arrière du substrat inférieur. En particulier, ces marques sont également utilisées pour l'alignement du substrat supérieur lors de son assemblage avec le reste de la structure.

Dans un procédé ou un dispositif tels que présentés ci-dessus et tels qu'expliqués plus loin :
- Le substrat supérieur peut être scellé au substrat intermédiaire à l'aide d'un cordon de scellement ;
- et/ou des moyens peuvent être prévus pour former contact électrique entre l'électrode inférieure et l'électrode supérieure et/ou des moyens peuvent être prévus pour former contact électrique entre l'électrode inférieure et le premier substrat ;

- et/ou le substrat intermédiaire est en silicium monocristallin ;
- et/ou le substrat supérieur est scellé au substrat intermédiaire de manière hermétique et/ou à l'aide d'un cordon de scellement et/ou par scellement eutectique ou par thermocompression à l'aide du cordon de scellement ;
- et/ou l'électrode inférieure est en matériau semi-conducteur, éventuellement dopé.

### BRÈVE DESCRIPTION DES DESSINS

- La figure 1 représente un gyroscope avec 2 éléments de détection à électrodes capacitives parallèles, au dessous et au dessus de la masse oscillante,
- les figures 2A-2K représentent, diverses étapes de réalisation d'un tel dispositif,
- les figures 3A - 3G représentent d'autres étapes de réalisation d'un autre dispositif.
- La figure 4 représente une structure de substrat SOI,
- La figure 5 représente vue de dessus simplifiée du substrat intermédiaire, avec une structure mobile,
- La figure 6 représente un système permettant un alignement de substrats.

### EXPOSÉ DÉTAILLÉ DE MODES DE RÉALISATION PARTICULIERS

Dans la suite, il est fait référence au collage moléculaire encore appelé collage direct ou scellement direct. Cette technique d'assemblage est décrite notamment par Q.Y. Tong dans « Silicon Wafer Bonding Technology for VLSI and MEMS applications », Edited by S.S. Iyer et A.J. Auberton-Hervé, 2002, INSPEC, London, Chapter 1, pages 1 - 20.

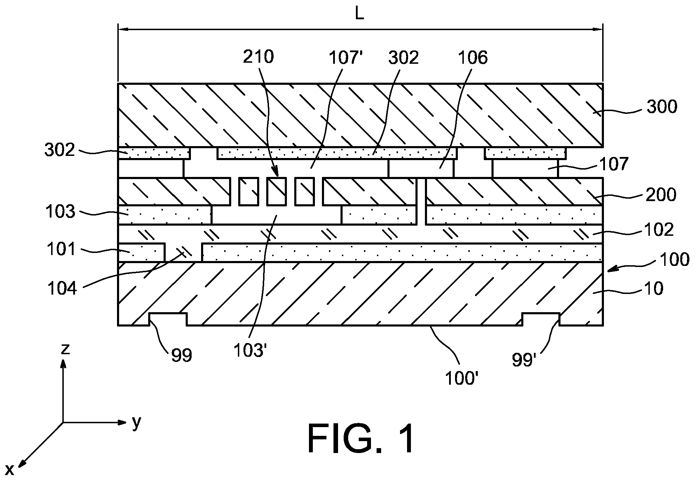

On décrit d'abord un exemple de structure illustrée en figure 1, qui est une vue en coupe.

Dans la suite, lorsqu'on parle de « substrat » 100, 200, 300, on peut également comprendre une « couche ». Par conséquent, pour ces trois éléments, on utilise indifféremment l'un ou l'autre de ces termes.

La structure de la figure 1 peut être réalisée dans 3 substrats 100, 200, 300 superposés et assemblés entre eux, le substrat 200 étant disposé entre le substrat 100 et le substrat 300.

Le substrat 200 a une épaisseur par exemple comprise entre quelques dizaines de µm et quelques centaines de µm, par exemple comprise entre 10 µm et 100 µm ou 500 µm.

Chacun de ces substrats s'étend principalement dans un plan xy, l'axe z étant perpendiculaire à chacun d'entre eux. Pour cette raison, le plan xy aussi appelé plan principal du dispositif. L'épaisseur de chaque substrat, mesurée suivant l'axe z, peut être très petite devant les extensions latérales du dispositif, c'est-à-dire devant les dimensions p et l de dispositif mesurées dans le plan xy ; p (mesurée selon l'axe x) est par exemple comprise entre 10µm et 10000µm et l (mesurée selon l'axe y) est par exemple comprise entre 10µm et 10000µm

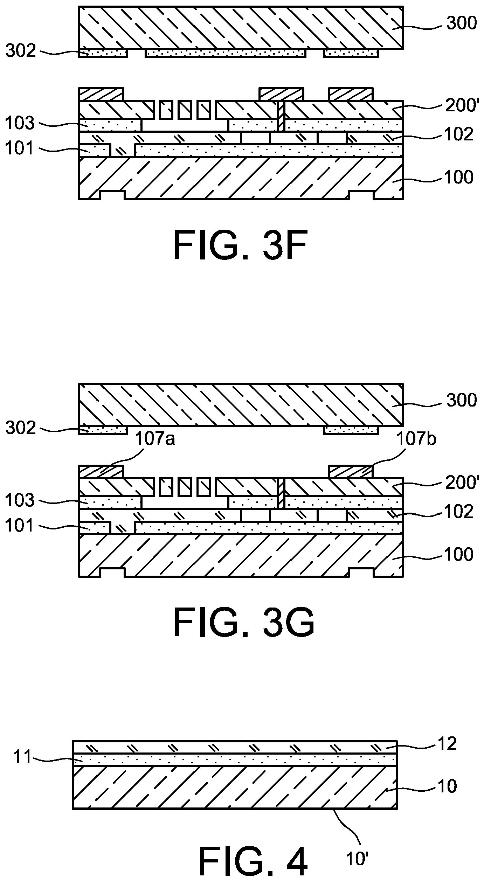

Le substrat 100 peut comporter une partie 10 en un matériau semi-conducteur, monocristallin ou polycristallin, par exemple en silicium, ou en SiGe ou en SiC ou en SiGeC ou en GaAs ou en InAs ou en InP ou en Ge. En variante, ce substrat 100 peut être un substrat de type « silicium sur isolant » (SOI), comportant, comme on le voit en figure 4, un substrat 10 en matériau semiconducteur, une couche 11 enterrée d'oxyde et une couche mince 12 de silicium. Dans ce cas la couche diélectrique 101 et l'électrode inférieure 102 sont formées respectivement par la couche 11 enterrée d'oxyde et la couche mince 12 de silicium, éventuellement dopée. L'intérêt de ce mode de réalisation est notamment la possibilité, une fois le dispositif complet réalisé, de pouvoir amincir ce substrat par la face arrière en s'arrêtant sur la couche diélectrique 11 et de former, par la face arrière 10' les interconnexions des moyens formant contact électrique dans la couche diélectrique 12.

En variante encore, le substrat 100 peut comporter plusieurs couches empilées, chaque couche pouvant par exemple être de l'un ou l'autre des matériaux mentionnés ci-dessus. L'intérêt d'empiler plusieurs couches réside notamment dans la possibilité d'empiler plusieurs capteurs, ou un capteur et son électronique associée pour un gain de place dans le composant final.

Le substrat 200 peut être un matériau semi-conducteur, monocristallin ou polycristallin, par exemple en silicium, ou en SiGe ou en SiC ou en SiGeC ou en GaAs ou en InAs ou en InP ou en Ge.

Le substrat 300 (Capot) peut être un substrat CMOS, comportant par exemple un autre capteur, ou un substrat 30 avec seulement une électrode supérieure, ou encore un capot de protection mécanique.

On appelle, dans la suite, partie ou côté inférieur du dispositif la partie tournée vers le substrat 100 et partie ou côté supérieur du dispositif la partie tournée du côté opposé, vers le substrat 300.

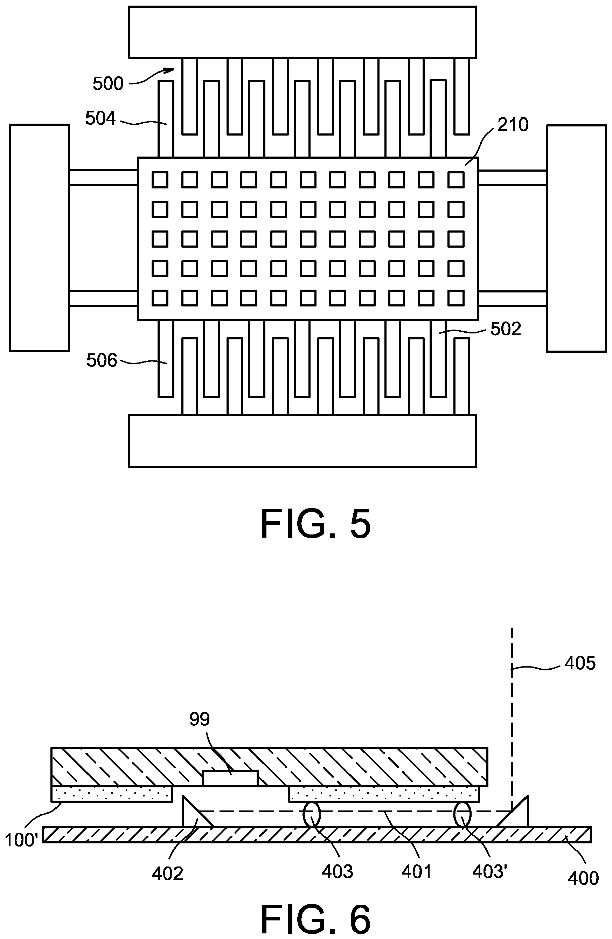

Un cordon de scellement hermétique 107 est réalisé entre les 2 substrats 100, 300 ; c'est par exemple un scellement eutectique ou par thermo compression, en utilisant des matériaux tels que AlGe, AuSn, AuGe, ou AuSi. Ce cordon 107 a une épaisseur qui permet de définir un espace 107' entre la face supérieure du substrat 200 et l'électrode supérieure 302. Cet espace 107' permet d'assurer une certaine mobilité de la masse mobile 210, suivant la direction z sensiblement perpendiculaire au plan du dispositif. On verra ci-dessous, en liaison avec la figure 5, un exemple de masse mobile pouvant, en outre, se déplacer dans le plan du dispositif, c'est-à-dire le plan xy.

Les substrats 100, 200 sont liés par collage moléculaire (qui permet d'assurer une bonne herméticité) au niveau de l'interface formée par la couche d'oxyde 103. Pour cette raison, chacun d'eux est de préférence en matériau semi-conducteur. La couche 103 est une couche sacrificielle : une partie de cette couche 103 est éliminée, de façon à former une cavité 103' permettant d'assurer à la masse mobile 210 une liberté de mouvement suivant la direction z, sensiblement perpendiculaire au plan du dispositif. La masse mobile 210 est disposée entre la cavité 103' et la
cavité 107'.

Sur le premier substrat 100 est formée une couche 101 d'oxyde, qui sert de support à une électrode 102. Cette couche 101 d'oxyde est donc disposée entre le substrat 100 et de la couche d'électrodes 102. Cette dernière peut être structurée, ou non. Dans le cas d'un substrat SOI (figure 4), ces couches sont formées, respectivement, par la couche 11 d'oxyde et la couche 12 de matériau semiconducteur, cette dernière pouvant être dopée.

Le substrat 200 est structuré de manière à définir une masse mobile 210.

La figure 5 représente une vue de dessus simplifiée du substrat 200, avec un exemple de structure de masse mobile 210, comportant en outre des moyens de détection du mouvement de la masse mobile dans le plan de la couche 200.

La structure de cette figure 5 représente une masse mobile 210 munie latéralement de peignes électrostatiques inter-digités, dont certains 500, 506 sont fixes, et d'autre 504, 506 mobile, un peigne mobile 504, 506 étant interdigité avec un peigne fixe 500, 502. Une variation de distance entre un peigne fixe et le peigne mobile qui lui fait face résulte d'un mouvement de ce dernier, qui provient du même d'un mouvement de la masse mobile 210, conduisant à une variation de capacité détectée par des moyens prévus à cet effet.

Par ailleurs, la masse mobile 210, est libre de se déplacer, par exemple essentiellement suivant l'axe Z. Mais le mouvement de la partie mobile peut avoir en outre une composante dans une direction sensiblement perpendiculaire à cet axe Z, ou encore dans un plan parallèle au plan principal du dispositif.

C'est ce déplacement qui peut être détecté par les électrodes inférieures 102 et supérieures 302.

L'électrode 302, dite électrode supérieure, est disposée sur la surface du substrat 300 tournée vers la masse mobile 210. Ainsi, cette dernière fait face à chacune des électrodes 102, 302 et un mouvement de la masse de 110 en dehors du plan du dispositif, sera détecté à l'aide de ces deux électrodes de détection capacitive. Ces deux électrodes sont disposées parallèlement au substrat 200 qui contient la masse mobile 210.

L'électrode supérieure 302 et l'électrode inférieure 102 permettent, en particulier, de détecter le mouvement de la masse mobile 210 en dehors du plan des couches.

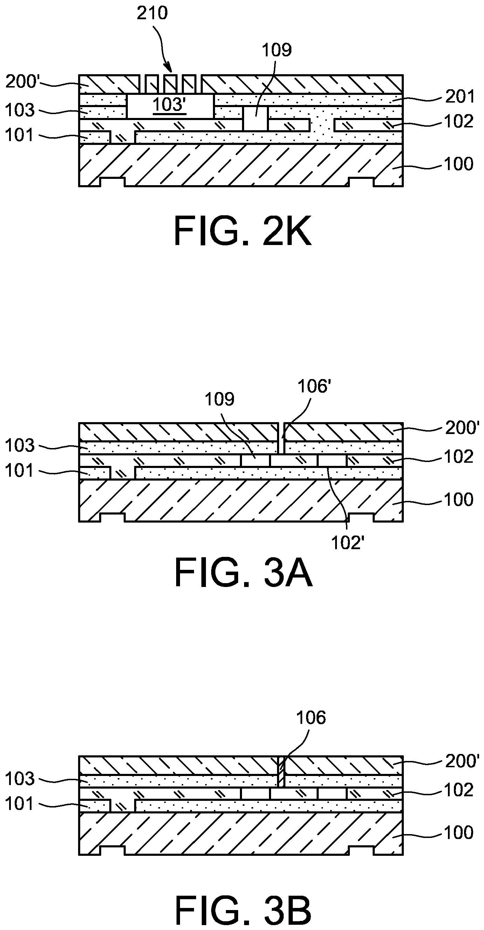

Cette détection est préférentiellement de type capacitive. Cependant, dans un autre mode de réalisation, illustré en figure 2K, le dispositif peut n'avoir qu'une électrode en regard de la partie mobile, la détection du mouvement de la partie mobile étant obtenu là aussi par variation capacitive entre la partie mobile et l'électrode. En variante, ce même dispositif de la figure 2K peut être muni d'un capot 300, sans électrode supérieure. Des contacts 104, 106 peuvent être prévus, respectivement entre l'électrode inférieure 102 et le substrat 100, et/ou entre ces électrodes et la surface du substrat 200. En particulier, les contacts 106 permettent d'établir une connexion électrique entre les électrodes inférieures 102 et supérieures 302.

Les références 99, 99' désignent des éventuelles marques d'alignement, formées en face arrière 100' du substrat 100, qui est la face qui ne supporte pas les couches 101, 102, 103.

On retrouve cette structure dans les autres exemples de réalisation présentés ci-dessous.

Ces aspects de l'invention peuvent valoir pour tous les dispositifs décrits dans la suite.

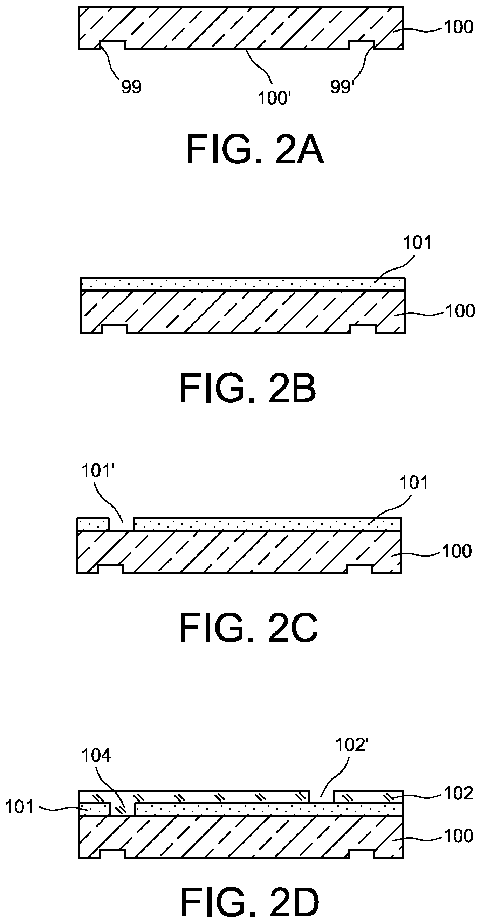

Les figures 2A-2K illustrent un premier exemple d'un procédé pour réaliser un dispositif tel que décrit ci-dessus.

Dans cet exemple de procédé, on explique comment on forme une couche structurelle 200 d'un MEMS en silicium monocristallin épais, ainsi qu'une électrode capacitive inférieure 102, pour une détection hors plan de la zone active du MEMS, avec reprise de contact 104 de cette électrode inférieure 102 dans le substrat.

On part (figure 2A) d'un substrat 100 qui peut être constitué de l'un des matériaux déjà mentionnés ci-dessus. Éventuellement, des marques 99, 99' d'alignement peuvent être réalisées en face arrière 100' de ce substrat, cette face arrière étant définie comme la face opposée à celle sur laquelle les diverses opérations de dépôt vont être réalisées. Le rôle de ces marques d'alignement sera expliqué plus loin. Ces marques d'alignement peuvent aussi être réalisées à un stade ultérieur.

Sur ce substrat 100, on dépose ou fait croître une couche isolante 101 (figure 2B), par exemple en dioxyde de silicium SiO2, ou en un autre matériau avec une constante diélectrique faible (par exemple inférieure à 5). Cette couche isolante permet d'isoler la future électrode inférieure 102 du substrat 100.

Comme on le voit sur la figure 2C, cette couche isolante 101 peut être structurée (par exemple par gravure chimique ou plasma), pour, par exemple, mettre ensuite en contact l'électrode inférieure 102 et le substrat 100. On forme alors une ou plusieurs ouvertures 101' dans la couche 101, dont une ou plusieurs peuvent déboucher sur la surface du substrat 100 sur laquelle la couche 101 a été déposée.

Une couche 102 d'électrode inférieure, par exemple en Silicium polycristallin ou en silicium amorphe dopé, ou en germanium polycristallin ou amorphe, ou, plus généralement, en un matériau semi-conducteur, éventuellement dopé, ou plus généralement en un matériau conducteur, est ensuite déposée sur la couche 101 (figure 2D). Un autre exemple particulier est le poly-Silicium dopé N ou P. Le choix d'un matériau semi-conducteur pour cette couche 102 permet la mise en œuvre d'un collage moléculaire. Cette couche 102 à par exemple une épaisseur pouvant aller de 100nm à 5 µm ou 10 µm. On peut choisir une technique de dépôt parmi l'une des techniques suivantes: LPCVD, PECVD, MBD, ou autres. Si la couche 101 a été préalablement structurée, alors le matériau constitutif de cette couche d'électrode atteint, par les ouvertures 101', la surface du substrat 100, assurant ainsi la formation d'un contact 104 avec ce dernier. Ce contact 104 permet de mettre à la masse certains éléments du dispositif ; on peut mettre aussi la face arrière 100' du substrat 100 à la masse.

Éventuellement, comme illustré en figure 2D, il est possible de structurer la couche 102, par formation d'une cavité 102', par exemple par gravure, cette gravure étant arrêtée sur la couche isolante 101.

Cette structuration de l'électrode inférieure permet d'en isoler certaines parties les unes des autres. Si on est parti d'un substrat SOI (figure 4), les cavités 101' auront été obtenues par gravure de la couche diélectrique 11 à partir de la face arrière 10'.

On procède ensuite au dépôt d'une couche isolante 103, dont l'épaisseur va permettre de définir la distance séparant l'électrode 102 du substrat 200, (et donc la distance séparant cette électrode de la future partie mobile 210) lorsque celui-ci sera assemblé avec le premier substrat 100. Cette couche est par exemple en un oxyde tel que l'oxyde de silicium (par exemple encore : oxyde TEOS) . Elle peut avoir une épaisseur de l'ordre de quelques centaines de nanomètres, par exemple comprise entre 50 nm et 500 nm ou 1 µm.

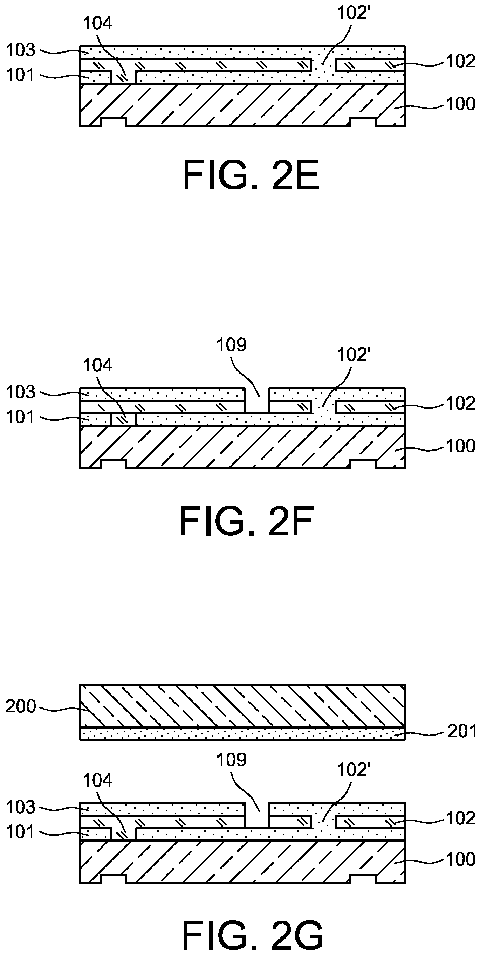

Cette couche isolante 103 peut être déposée seulement sur l'électrode inférieure 102, comme illustré sur la figure 2E ou seulement sur le substrat 200 ou en partie sur l'électrode inférieure 102 et en partie sur le substrat 200 (comme on le voit sur la figure 2G, avec les couches 103 et 201). Quelle que soit la possibilité retenue, cette couche isolante formera une couche sacrificielle qui sera gravée pour libérer la masse oscillante 210, comme expliqué ci-dessous.

Si la couche 102 a été préalablement structurée, le matériau de la couche isolante 103 remplit aussi les portions 102' structurées ou gravées dans la couche 102, et vient contacter la surface supérieure de la couche isolante 101. L'isolation de certaines parties de l'électrode inférieure 102 pourra être assurée par cette couche isolante 103.

Éventuellement, comme illustré en figure 2F, une cavité 109 peut être gravée dans la couche isolante 103 et dans la couche d'électrode 102, la gravure étant arrêtée sur la couche isolante 101. Il est donc possible de structurer la couche 103 et éventuellement la couche 102. L'isolation entre différentes parties de l'électrode inférieure pourra être assurée par ces cavités 109 et/ou par la présence, dans cette couche d'électrode, de zones en matériau isolant 103, comme expliqué ci-dessus.

Il est en outre possible, en vue d'un collage de type moléculaire, de réaliser :
- une densification de cette couche 103, par exemple par oxydation à une température proche de la température de collage (par exemple 1050°C), pour que toutes les couches voient un budget thermique similaire à celui du collage (cette étape permet notamment d'effectuer un dégazage des couches). Cette étape de densification permet d'obtenir la même densité des couches 103 et 201, pour une meilleure efficacité de collage pour avoir des vitesses de gravure similaires lors de la libération finale (on réalise, plus loin, une gravure de ces 2 couches sacrificielles sous la partie mobile),
- et/ou un polissage de la couche 103, ce qui permet d'obtenir une surface très plane pour le scellement moléculaire.

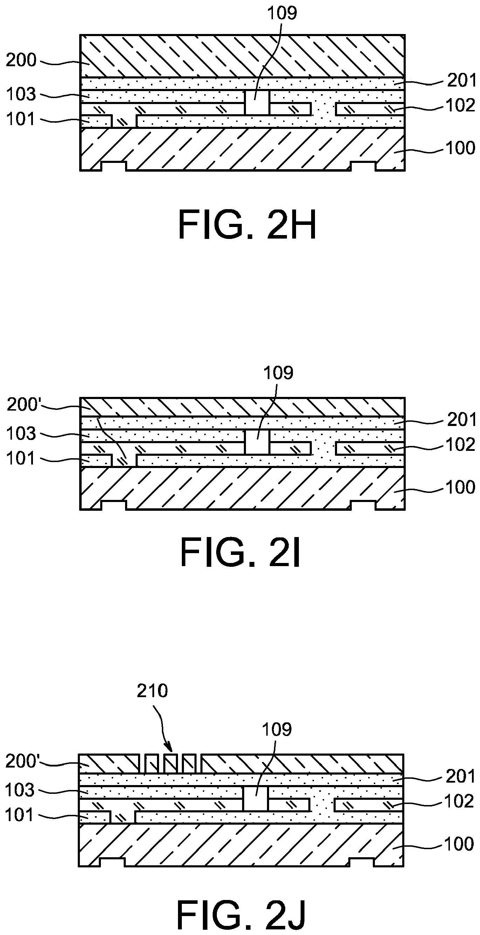

On peut ensuite réaliser un collage direct (ou collage moléculaire) de ce substrat 100, ainsi préparé, avec un deuxième substrat 200, de préférence en silicium monocristallin épais (figure 2G). C'est alors la surface de la couche isolante 103 qui vient en contact avec le substrat 200 ou avec une éventuelle couche isolante 201 formée sur ce substrat 200 (figure 2H) .

Que la couche 103 soit structurée, ou pas (autrement dit : qu'il y ait présence, ou pas, d'une cavité 109), un collage direct des 2 substrats 100, 200 peut être réalisé. Cette étape peut être réalisée à température ambiante, sous pression atmosphérique, notamment si le scellement se fait sans cavité 109 ou sous vide.

Le processus peut être complété par un recuit de consolidation de l'interface de collage (typiquement avec une température de 1000°C à 1200°C pendant quelques heures).

Le substrat 200 peut ensuite être aminci (figure 2I), à partir de sa surface opposée à celle assemblée avec le substrat 100, par exemple par une technique de polissage. On cherche alors obtenir une épaisseur qui peut être comprise entre 10 µm et 100µm, notamment dans le cas d'une application MEMS.

La partie mobile du MEMS est ensuite définie dans la couche 200' (qui résulte de l'amincissement du substrat 200) par gravure (plasma par exemple) de la couche 200', avec arrêt sur la couche isolante 201, 103, comme illustrée en figure 2J.

Cette étape permet de réaliser des tranchées verticales 210 qui vont définir le contour des parties mobile du MEMS.

Enfin, une étape de gravure des couches sacrificielles 201, 103, sous la couche 200' (figure 2K), permet de libérer la partie mobile que l'on vient de définir. On forme ainsi la cavité 103' entre la partie mobile 210 et l'électrode 102.

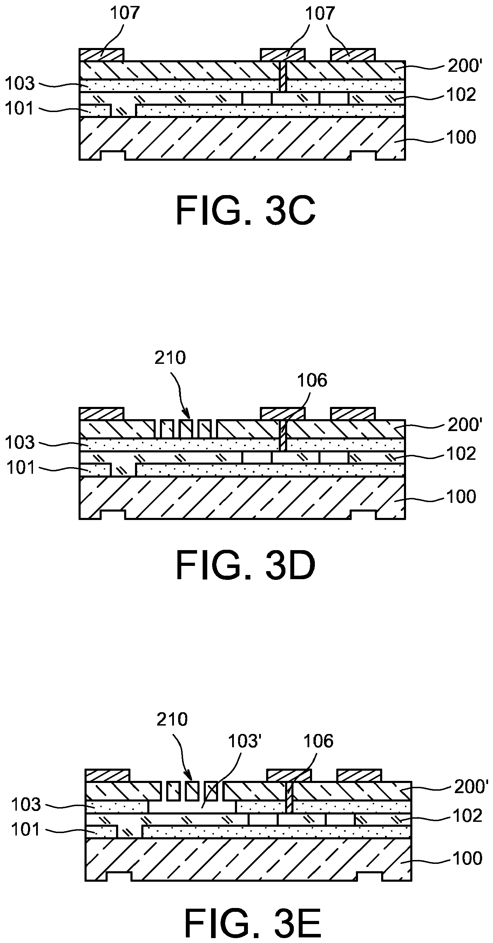

Il est possible d'arrêter le procédé à ce stade, auquel cas on ne réalise pas d'assemblage avec un substrat ou capot 300, et donc il n'y pas de 2^{ème} électrode. Mais on peut aussi continuer le processus de fabrication avec la formation d'un cordon 107 et l'assemblage avec un capot comme expliqué plus loin, en liaison avec les figures 3C-3F (avec ou sans le contact 106). Si ce capot comporte une électrode 302, on peut alors réaliser un dispositif à 2 électrodes. Le capot peut être un capot de protection mécanique, sans être muni d'électrode.

Un exemple particulier de ce procédé, qui permet d'obtenir une interface de collage direct, entre une couche 103 en SiO2 et une couche 201 en SiO2, de bonne qualité (c'est-à-dire dont la vitesse de gravure n'est pas différente de celle de la couche sacrificielle), est le suivant :
* Dépôt de la couche d'électrode inférieure 102, par exemple du poly-Silicium dopé N ou P avec une épaisseur pouvant aller de 100nm à quelques microns (figures 2A - 2D),
* Dépôt d'une couche 103 de diélectrique, par exemple de l'oxyde TEOS, avec une épaisseur de l'ordre de quelques centaines de nanomètres (figure 2E),
* Densification complète de cette couche d'oxyde 103 par oxydation à une température proche de la température de collage (par exemple 1050°C), pour que toutes les couches voient un budget thermique similaire à celui du collage (par effet de dégazage des couches),
* Polissage de l'oxyde 103 avant collage moléculaire, ce qui permet d'obtenir une surface parfaitement plane pour le scellement moléculaire,
* Structuration, ou non, des couches 102 et 103,
* Collage direct à température ambiante, sous pression atmosphérique, si le scellement se fait sans cavité ou sous vide.
* Recuit de consolidation de l'interface de collage entre les deux substrats 100, 200, typiquement avec une température de 1000°C à 1200°C pendant quelques heures,
* Amincissement du substrat 200 jusqu'à l'épaisseur recherchée pour la partie mobile : entre 10 µm et 100µm pour une application MEMS, cet amincissement du substrat 200 peut-être réalisé par « grinding » et/ou polissage,
* définition de la partie mobile dans la couche 200' par gravure de celle-ci, par exemple par technique plasma, avec arrêt sur la couche isolante 201, 103,
* libération de la partie mobile, par gravure des couches sacrificielles 201, 103 sous la partie mobile.

Comme déjà indiqué ci-dessus, des marques d'alignement 99, 99' peuvent avoir été préalablement formées, par exemple par gravure, en face arrière du substrat 100.

En effet, après collage direct et amincissement du substrat 200, de nouveaux niveaux peuvent être réalisés sur la couche 200', en les alignant sur les niveaux précédents, obtenus avant le collage direct. Or ces niveaux précédents ne sont plus visibles, par reconnaissance optique, par un équipement de lithographie classique.

Pour surmonter cette difficulté, les différents niveaux générés sur la face avant du substrat 100 sont alignés sur ces marques 99, 99' en face arrière, grâce à un système de reconnaissance optique.

Un exemple d'un tel dispositif est représenté schématiquement sur la figure 6. La face arrière 100' du substrat, sur laquelle les marques 99, 99' sont réalisées, est posée sur un « chuck » (ou plateau) 400 à la surface duquel sont prévus des moyens formant un guidage optique 401. Ces moyens comportent essentiellement des moyens optiques tels que des lentilles 403, 403', et des miroirs 402, 402' ; ils vont permettre de mener de guider un faisceau 405 vers la face inférieure 100' du substrat, pour venir lire la position des marques 99. Ce dispositif permet de repérer la position exacte des marques générées en face arrière et donc d'aligner, par rapport à ces marques, les autres niveaux, en face avant.

De même, après collage et amincissement du substrat 200, tous les niveaux générés sur la face avant de la couche 200' sont alignés sur ces marques 99, 99'.

Des substrats en nombre quelconque peuvent être collés et amincis, comme le substrat 200, et tous les niveaux générés sur les faces avant de ces substrats peuvent être alignés sur les marques 99, 99' de la face arrière du substrat 100 ou réalisés en tenant compte de la position de ces marques, comme expliqué ci-dessus.

On décrit maintenant, en liaison avec les figures 3A - 3F comment on peut établir un contact entre les électrodes capacitives inférieures 102 et supérieures 302.

À cette fin, on part d'un substrat tel que celui obtenu à l'issue de l'étape décrite ci-dessus en liaison avec la figure 2I. Ce substrat comporte donc au moins d'une électrode inférieure 102, une couche sacrificielle 103 et une couche structurelle 200'. Il peut en outre comporter une ou plusieurs zones 101' de contact entre l'électrode 102 et le substrat 100.

L'électrode inférieure 102 peut comporter une ou plusieurs zones 102', 109 d'isolation de portions de l'électrode entre elles.

On définit préalablement la position d'un ou plusieurs vias 106'. Ces vias sont ensuite gravés dans la couche structurelle 200' et la couche isolante 103, l'électrode inférieure 102 jouant alors le rôle de couche d'arrêt. Cette gravure est préférentiellement de type plasma (figure 3A).

Puis, une couche de matériau conducteur 106 est déposée en surface, cette couche est par exemple en polysilicium dopé, en Métal, ou en poly-Ge, etc (figure 3B). Ce matériau vient également remplir les cavités ou via 106'.

Cette couche peut être soit directement structurée (et donc déposée dans les vias 106', mais pas sur la surface du substrat 200'), soit éliminée de la surface du substrat 200' par polissage et/ou gravure totale sans masque de résine, seul restant le matériau présent dans les via 106'.

Puis (figure 3C) une nouvelle couche de matériau conducteur 107, pouvant avoir une nature différente du matériau de la couche 106 est déposée sur la couche 200', puis structurée, par exemple par gravure. Cette étape permet de définir la localisation des futurs cordons de soudure avec le capot du dispositif. Au moins l'un de ces cordons est disposé en contact avec le matériau 106 de remplissage d'au moins l'un des vias 106'. L'épaisseur de ces cordons 107 va définir la distance entre la surface supérieure de la partie mobile 210 et l'électrode supérieure 302. En variante, on peut avoir tout ou partie des cordons 107 formée préalablement sur l'électrode supérieure 302 et non pas sur le substrat 200'.

On procède ensuite aux étapes de définition de la structure mobile 210, puis de gravure de la couche sacrificielle 103 (figures 3D et 3E), comme déjà décrit ci-dessus.

Par ailleurs, on a préparé un autre substrat 300, appelé capot, sur une surface duquel une couche 302 de matériau conducteur a été déposée et structurée. Cette couche 302 est en un matériau métallique ou en un alliage métallique tel que par exemple AlCu, ou AuSn, ou AlSI, ou AuGe etc.... (figure 3F). Eventuellement, des cordons 107 sont formés sur cette couche conductrice 302.

Les deux substrats sont ensuite scellés de manière hermétique, par exemple par scellement eutectique ou par thermo compression, sous vide ou atmosphère contrôlé. La couche 302 peut alors venir en contact du cordon de scellement 107, de manière à faire face à la partie mobile 210, qui est alors située entre les deux électrodes 102, 302. Ou bien, on amène les cordons, s'ils sont situés sur la couche 302, sur la couche 200', l'un d'entre eux étant positionné en contact avec le matériau de remplissage du via 106'. On obtient alors la structure de la figure 1.

La couche 302 assure alors en outre une fonction de scellement hermétique, permettant d'avoir un bon niveau de vide dans la cavité scellée. Par les contacts 106 et le cordon 107, est en outre assuré un contact entre les électrodes supérieures 302 et inférieures 102. De préférence, le scellement des 2 substrats de 100, 300 a lieu sous vide ou atmosphère contrôlée, afin de garder le même niveau de vide dans la cavité, que dans l'enceinte dans laquelle on effectue le scellement. La fréquence de résonance (et, donc, la réponse du système) dépend du niveau de vide dans la cavité et le contrôle de l'atmosphère (en fiat de la pression) dans cette dernière permet de fixer cette fréquence. Our obtenir une fréquence déterminée, on fixe une pression déterminée.

Le scellement hermétique permet en outre de protéger la partie mobile 210 du dispositif vis-à-vis de l'atmosphère ambiante.

Le dispositif est alors prêt pour réaliser une détection d'un mouvement de la partie mobile 210, ce mouvement ayant lieu hors du plan du dispositif, c'est-à-dire essentiellement suivant la direction z.

Mais le mouvement de la partie mobile peut avoir en outre une composante dans un plan parallèle au plan principal du dispositif, donc perpendiculairement à Z.

La détection est assurée par les électrodes capacitives 102, 302. Le signal obtenu peut être transmis à des moyens de traitement et de mémorisation des données, non représentés sur les figures.

Dans l'un quelconque des modes de réalisation ci-dessus :
- les reprises de contact en vue de la mesure des tensions détectées sur les électrodes pourront être réalisées à travers le substrat 100 et/ou à travers le substrat capot 300 ;
- et/ou l'électrode supérieure et/ou l'électrode inférieure peuvent être gravées pour ne pas être dans les zones de scellement.

Le substrat capot 300 peut être par exemple un substrat CMOS. Dans ce cas, le dernier niveau métallique structuré (par exemple en AlCu, ou en AlSi etc...) de ce substrat peut être utilisé comme électrode supérieure 302 et comme couche de scellement hermétique.

L'invention n'est pas limitée à la réalisation de composants MEMs à électrodes capacitives, elle peut s'appliquer à toute structure comportant uniquement une électrode inférieure enterrée. Le procédé ci-dessus, avec formation de 2 électrodes 102, 302 peut-être modifié et simplifié pour obtenir un dispositif à une seule électrode. Il suffit alors de ne pas déposer le matériau 302 sur le substrat 300. Si on souhaite réaliser un scellement hermétique (par exemple pour une protection mécanique du dispositif ou une protection contre l'air ambiant), le matériau 302 est déposé uniquement au dessus de certains cordons de scellement 107a, 107b, comme sur la figure 3G. Un dispositif avec uniquement une électrode inférieure peut également détecter un mouvement de la partie mobile selon l'axe z, mais de façon moins sensible.

Dans un procédé selon l'invention, le collage moléculaire permet d'assurer un caractère hermétique, ce qui permet le fonctionnement sous vide contrôlé d'une structure mobile, par exemple un gyroscope. Pour ce scellement moléculaire on met en oeuvre un haut budget thermique ou une température élevée (par exemple entre 900°C et 1200°C ; typiquement 1100°C pour un scellement SiO2-SiO2). Les matériaux à assembler, qui sont en présence lors du scellement moléculaire des substrats, sont donc de préférence des matériaux semi-conducteurs, qui peuvent supporter ce budget thermique élevé ou cette température élevée; en particulier l'électrode inférieure est avantageusement en poly-Si dopé.

L'invention peut être appliquée à la réalisation de composants inertiels Microsystèmes ou nanosystèmes. C'est en particulier le cas dans le domaine de l'automobile, pour la formation d'accéléromètres dans les airbags, ou de gyromètres pour la correction de trajectoire.

Elle peut être également être appliquée à la réalisation de capteurs à ultrasons, pour le diagnostique médical (sonde pour échographie). Elle permet notamment la réalisation de dispositifs de type CMUT (Capacitive Micromachined Ultrasonic).

Elle permet également la réalisation de microphones, ou encore de commutateurs RF ou de capteurs de pression, par exemple dans le domaine automobile, aéronautique ou aérospatial.

## Revendications

1. Procédé pour réaliser un dispositif de type Micro-système et/ou Nano-système comportant :
- la formation d'un premier substrat (100) comportant au moins une électrode inférieure (102), et une première couche diélectrique (103),
- puis, l'assemblage, par collage moléculaire, d'un substrat intermédiaire (200') avec le premier substrat,
- puis, la définition d'une partie mobile (210) dans le substrat intermédiaire (200'),
- puis, la formation d'une cavité (103') dans la première couche diélectrique (103), libérant ainsi la partie mobile (210), de façon à ce que celle-ci soit en regard d'au moins une partie de l'électrode inférieure,
- puis, l'assemblage d'un substrat supérieur (300), avec le substrat intermédiaire (200'), de sorte que ladite partie mobile puisse être mise en mouvement entre l'électrode inférieure et le substrat supérieur.

2. Procédé selon la revendication 1, le substrat supérieur comportant au moins une électrode supérieure (302), l'assemblage étant tel que la partie mobile soit en regard d'au moins une partie de l'électrode supérieure, ladite partie mobile pouvant être mise en mouvement entre l'électrode inférieure et l'électrode supérieure.

3. Procédé selon l'une des revendications 1 ou 2, comportant en outre la formation de moyens (104) formant contact électrique entre l'électrode inférieure (102) et le premier substrat et/ou la formation de moyens (106) formant contact électrique entre l'électrode inférieure (102) et, éventuellement, l'électrode supérieure (302).

4. Procédé selon l'une des revendications 1 à 3, le substrat supérieur (300) étant scellé au substrat intermédiaire (200'), à l'aide d'un cordon de scellement (107), par exemple par scellement eutectique ou par thermocompression, et/ou le substrat supérieur (300), étant scellé au substrat intermédiaire (200') de manière hermétique.

## Patentansprüche

1. Verfahren zum Herstellen einer Vorrichtung vom Typ Mikrosystem und/oder Nanosystem, umfassend:
- Ausbilden eines ersten Substrats (100), das zumindest eine untere Elektrode (102) und eine erste dielektrische Schicht (103) enthält, dann
- Zusammenfügen durch molekulare Bindung eines Zwischensubstrats (200') mit dem ersten Substrat, dann
- Definieren eines beweglichen Teils (210) in dem Zwischensubstrat (200'), dann
- Ausbilden eines Hohlraums (103') in der ersten dielektrischen Schicht (103), wodurch der bewegliche Teil (210) freigegeben wird, so dass dieser zumindest einem Teil der unteren Elektrode gegenüberliegt, dann
- Zusammenfügen eines oberen Substrats (300) mit dem Zwischensubstrat (200'), so dass der bewegliche Teil zwischen der unteren Elektrode und dem oberen Substrat in Bewegung gesetzt werden kann.

2. Verfahren nach Anspruch 1, wobei bei einem zumindest eine obere Elektrode (302) enthaltenden oberen Substrat die Zusammenfügung derart ist, dass der bewegliche Teil zumindest einem Teil der oberen Elektrode gegenüberliegt, wobei der bewegliche Teil zwischen der unteren Elektrode und der oberen Elektrode in Bewegung gesetzt werden kann.

3. Verfahren nach einem der Ansprüche 1 oder 2, ferner umfassend das Ausbilden von Mitteln (104), die einen elektrischen Kontakt zwischen der unteren Elektrode (102) und dem ersten Substrat herstellen und/oder das Ausbilden von Mitteln (106), die einen elektrischen Kontakt zwischen der unteren Elektrode (102) und gegebenenfalls der oberen Elektrode (302) herstellen.

4. Verfahren nach einem der Ansprüche 1 bis 3, wobei das obere Substrat (300) mittels einer Versiegelungswulst (107), beispielsweise durch eutektisches Bonden oder Thermokompression, mit dem Zwischensubstrat (200') versiegelt wird und/oder das obere Substrat (300) mit dem Zwischensubstrat (200') hermetisch versiegelt wird.

## Claims

1. A method to produce a device of the micro-system and/or nano-system type, comprising:
- forming a first substrate (100) including at least one lower electrode (102), and a first dielectric layer (103),
- then assembling, by molecular bonding, an intermediate substrate (200'), with the first substrate,
- then defining a moving portion (210) in the intermediate substrate (200'),
- then forming a cavity (103') in the first dielectric layer (103), thus making the moving portion (210) free, such that it is facing at least a portion of the lower electrode,
- then assembling an upper substrate (300) with the intermediate substrate (200'), such that the said moving portion can be made to move between the lower electrode and the upper substrate.

2. A method according to claim 1, the upper substrate comprising at least one upper electrode (302), where the assembly is such that the moving portion is facing at least a portion of the upper electrode, and where the said moving portion can be made to move between the lower electrode and the upper electrode.

3. A method according to one of claims 1 or 2, also including forming means (104) forming an electrical contact between the lower electrode (102) and the first substrate and/or forming means (106) forming an electrical contact between the lower electrode (102) and, possibly, the upper electrode (302) .

4. A method according to one of the claims 1 to 3, where the upper substrate (300) is fixed to the intermediate substrate (200') by means of a sealing bead (107), for example by eutectic sealing or by thermocompression, and/or the upper substrate (300) is fixed to the intermediate substrate (200') hermetically.
